# EUROPÄISCHE PATENTANMELDUNG

(11) **EP 2 363 780 A2**
(43) Veröffentlichungstag der Anmeldung: **07.09.2011**
(21) Anmeldenummer: 11001584.9
(22) Anmeldetag: 25.02.2011
(51) Int. Cl.: G06F 1/20

(54) **System zum erwärmen eines elektronischen Schaltkreises**

(30) Priorität: 01.03.2010 DE 102010009736
(71) Anmelder: Giesecke & Devrient GmbH, 81677 München (DE)
(72) Erfinder: Eckardt, Stefan, 82291 Mammendorf (DE)

(57) **Zusammenfassung**

Auf einem elektronischen Schaltkreis (2; 22) zur Verarbeitung von Daten werden, falls eine festgestellte Temperaturcharakteristik mindestens eine vorgegebene Bedingung erfüllt, beispielsweise wenn die Schaltkreistemperatur unter eine vorgegebene Mindesttemperatur sinkt, in einem Aufwärmmodus energieverbrauchende Operationen durchgeführt, um den Schaltkreis (2; 22) auf diese Weise gezielt zu erwärmen.

## Beschreibung

Die vorliegende Erfindung betrifft ein System, das einen elektronischen Schaltkreis zur Verarbeitung von Daten umfasst, der vorzugsweise Bestandteil eines machine-to-machine (M2M) - Kommunikationsmoduls ist, sowie ein Verfahren zum Erwärmen eines derartigen elektronischen Schaltkreises.

Elektronische Schaltkreise sind in vorbestimmten Temperaturbereichen von Tₘᵢₙ bis Tₘₐₓ sicher, d.h. fehlerfrei, betreibbar. Um zu vermeiden, dass die Temperatur eines elektronischen Schaltkreises den Wert Tₘₐₓ überschreitet, sind Techniken zum Kühlen des Schaltkreises, zum Reduzieren der Taktfrequenz ggf. in Kombination mit der Versorgungsspannung oder auch zum Deaktivieren einzelner Prozessorkerne des Schaltkreises bekannt.

In diesem Zusammenhang beschreibt die WO 2007/081466 eine integrierte Schaltung mit mehreren Kernen, die mit unterschiedlichen Taktfrequenzen betrieben werden können, um zu vermeiden, dass die integrierte Schaltung zu heiß wird. Die WO 2008/093606 offenbart eine Vorrichtung zum Beschreiben einer Speicherkarte, bei der die Zugriffsgeschwindigkeit auf den Speicher der Karte derart angepasst wird, dass der Schaltkreis der Karte nicht zu heiß wird. Die US 6,217,213 beschreibt eine Vorrichtung zum Bestimmen einer Temperatur basierend auf dem Strom, der durch eine Diode fließt. Dabei wird z.B. ein Hardwaremodul mit einer solchen Temperaturmessvorrichtung ausgestattet, um mit dem Hardwaremodul eine Temperatur zu überwachen.

Bei bestimmten Anwendungen muss jedoch auch dafür gesorgt werden, dass die Temperatur eines elektronischen Schaltkreises nicht unter die zum sicheren, d.h. fehlerfreien Betrieb notwendige Mindesttemperatur Tₘᵢₙ abfällt. Dies ist insbesondere häufig bei so genannten machine-to-machine (M2M)-Systemen von Bedeutung. M2M-Systeme sind Kommunikationssysteme, die dem automatisierten Informationsaustausch zwischen Endgeräten wie Maschinen, Automaten, Fahrzeugen oder Containern untereinander oder mit einer zentralen Leitstelle dienen. Typische Anwendungen derartiger Systeme sind die Fernüberwachung und die Fernwartung. Derartige M2M-Systeme werden daher oft in anderen Umgebungsbedingungen eingesetzt als herkömmliche "Consumer"-Elektronik und müssen dabei meist in einem weiteren Umgebungstemperaturbereich zuverlässig arbeiten (z.B. schon ab Tₘᵢₙ=-40 °C) als herkömmliche "Consumer"-Elektronik (z.B. erst ab Tₘᵢₙ=-25 °C).

Um zu vermeiden, dass die Temperatur eines elektronischen Schaltkreises bei derart niedrigen Umgebungstemperaturen unter die zum fehlerfreien Betrieb des Schaltkreises erforderliche Mindesttemperatur Tₘᵢₙ abfällt, sind (ggf. geregelte) Heizsysteme bekannt.

Eine derartige Heizeinrichtung erhöht jedoch die Kosten und den Planungsaufwand des Systems. Insbesondere bei einem einfachen, preiswerten System kann die Heizeinrichtung mehr kosten als der Schaltkreis. Häufig werden daher keine Heizeinrichtungen verwendet. Stattdessen wird das System mit einem Temperatursensor ausgestattet und der Schaltkreis wird abgeschaltet, wenn die Temperatur des Schaltkreises unter die zum fehlerfreien Betrieb erforderliche Mindesttemperatur Tₘᵢₙ fällt. Ein Abschalten des Systems sollte aber natürlich möglichst vermieden werden.

Aufgabe der vorliegenden Erfindung ist es daher, einen elektronischen Schaltkreis mit möglichst einfachen Mitteln auf einer erforderlichen Betriebstemperatur zu halten.

Diese Aufgabe wird durch die Systeme sowie entsprechende Betriebsverfahren mit den Merkmalen der unabhängigen Ansprüche gelöst. In davon abhängigen Ansprüchen sind vorteilhafte Ausgestaltungen und Weiterbildungen der Erfindung angegeben.

Gemäß einem ersten Aspekt der Erfindung wird zunächst eine Temperaturcharakteristik festgestellt und, wenn die festgestellte Temperaturcharakteristik mindestens eine erste vorgegebene Bedingung erfüllt (beispielsweise liegt die Betriebstemperatur unter einem vorgegebenen Wert), der Schaltkreis in einem Aufwärmmodus betrieben, in dem auf dem Schaltkreis energieverbrauchende Operationen durchgeführt werden, die den Schaltkreis über einer Mindesttemperatur halten. Der Aufwärmmodus ist dabei so angelegt, dass bedarfsweise auch solche energieverbrauchenden Operationen auf dem Schaltkreis durchgeführt werden, die keine über die Wärmegewinnung hinausgehende Funktion haben.

Unter einer Temperaturcharakteristik ist dabei eine relevante Eigenschaft der Temperatur zu verstehen, also z.B. der eigentliche Temperaturwert oder auch ein zeitlicher Temperaturverlauf.

Die vorgegebene Bedingung für die Temperaturcharakteristik wird dementsprechend so gewählt, dass das System in der Lage ist, die Temperatur des Schaltkreises durch Betreiben des Schaltkreises im Aufwärmmodus über der vorgegebenen (zeitunabhängigen oder zeitabhängigen) Mindesttemperatur zu halten oder über die Mindesttemperatur zu bringen. Bei dieser Mindesttemperatur kann es sich z.B. um eine Mindesttemperatur Tₘᵢₙ handeln, unterhalb derer ein fehlerfreier Betrieb des Schaltkreises nicht mehr gewährleistet ist.

Zum Erwärmen des Schaltkreises werden dabei Operationen, die eine über die Wärmegewinnung hinausgehende Funktion haben, bevorzugt. Um sicherzustellen, dass der Schaltkreis ausreichend erwärmt wird, sind jedoch bedarfsweise auch energieverbrauchende Operationen erforderlich, die keine über die Wärmegewinnung hinausgehende Funktion haben.

Operationen, die eine über die Wärmegewinnung hinausgehende Funktion haben, können insbesondere Selbstwartungsfunktionen des Schaltkreises sein, wie z.B. das Auffrischen einer lange nicht mehr beschriebenen Seite eines nicht-flüchtigen Speichers (z.B. eines EEPROM- oder Flash-Speichers), oder auch das Vorziehen von Rechenoperationen, bei denen erwartet wird, dass ihre Ergebnisse später benötigt werden.

Operationen, die keine über die Wärmegewinnung hinausgehende Funktion haben, können beliebige Operationen auf dem Schaltkreis sein, z.B. (abgesehen von der Wärmegewinnung) sinnlose Rechenoperationen und Zugriffe auf einen nicht-flüchtigen Speicher oder einen RAM-Speicher.

Prinzipiell kann es sich sowohl bei den Operationen, die eine über die Wärmegewinnung hinausgehende Funktion haben, als auch bei den Operationen, die keine über die Wärmegewinnung hinausgehende Funktion haben um Rechenoperationen, Speicherzugriffe auf einen nicht-flüchtigen Speicher oder einen RAM-Speicher, insbesondere das Löschen von EEPROM- oder Flash-Speicherzellen und Schreibzugriffe auf EEPROM- oder Flash-Speicherzellen, oder auch um das zusätzliche Betreiben von Hardwaremodulen (z.B. einem Zufallszahlengenerator, einem Co-Prozessor, insbesondere einem Verschlüsselungs-Coprozessor) handeln.

Das System umfasst vorzugsweise eine Einrichtung zum Feststellen einer Temperatur des Schaltkreises oder einer Temperatur in der Umgebung des Schaltkreises oder eines Verlaufs einer Temperatur des Schaltkreises oder einer Temperatur in der Umgebung des Schaltkreises. Um festzustellen, ob und wie der Schaltkreis erwärmt werden soll, kann folglich sowohl eine Charakteristik der festgestellten Temperatur des Schaltkreises als auch der in der Umgebung des Schaltkreises festgestellten Temperatur als auch eines entsprechenden Temperaturverlaufs herangezogen werden.

Wenn die festgestellte Temperaturcharakteristik eine erste vorgegebene Bedingung erfüllt, beispielsweise wenn die Schaltkreistemperatur unter der Mindesttemperatur Tₘᵢₙ liegt, wird der Schaltkreis vorzugsweise in einem exklusiven Aufwärmmodus betrieben, in dem ausschließlich solche energieverbrauchenden Operationen durchgeführt werden, bei denen es unbedeutend ist, ob sie fehlerfrei durchgeführt werden. Bei den energieverbrauchenden Operationen des exklusiven Aufwärmmodus kann es sich also um beliebige, der Wärmeerzeugung dienende Schaltkreisoperationen handeln, deren fehlerhafte Ausführung keinerlei negative Auswirkungen oder zumindest keine kritischen Auswirkungen, wie z.B. die Verursachung eines Datenverlusts, hat.

Normalerweise handelt es sich bei den energieverbrauchenden Operationen des exklusiven Aufwärmmodus um die zuvor beschriebenen Operationen, die keine über die Wärmegewinnung hinausgehende Funktion haben, wobei allerdings zugleich sichergestellt sein muss, dass es keine negativen Auswirkungen hat, wenn die Operationen fehlerhaft ausgeführt werden. Allerdings ist es, zumindest prinzipiell, auch denkbar, auch in dem exklusiven Aufwärmmodus Operationen durchzuführen, die eine über die Wärmegewinnung hinausgehende Funktion haben, z.B. das Generieren von Zufallszahlen.

Dementsprechend wird die erste vorgegebene Bedingung so gewählt, dass der Schaltkreis zumindest dann in dem exklusiven Aufwärmmodus betrieben wird, wenn auf Grund der festgestellten Temperaturcharakteristik davon auszugehen ist oder damit gerechnet werden kann, dass der Schaltkreis oder zumindest wesentliche Teile davon nicht die zum fehlerfreien Betrieb erforderliche Mindesttemperatur Tₘᵢₙ aufweist.

Dabei wird der Schaltkreis vorzugsweise in dem exklusiven Aufwärmmodus betrieben, wenn die festgestellte Temperatur unterhalb einer vorgegebenen unteren kritischen Temperatur liegt. Die untere kritische Temperatur ist dementsprechend ein Temperaturwert der festgestellten Temperatur des Schaltkreises oder der festgestellten Temperatur in der Umgebung des Schaltkreises, unterhalb dessen ein sicherer und zuverlässiger Betrieb des Schaltkreises nicht mehr gewährleistet ist. Mit anderen Worten ist, wenn die festgestellte Temperatur unterhalb der vorgegebenen unteren kritischen Temperatur liegt, nicht mehr gewährleistet, dass der Schaltkreis oder wesentliche Teile des Schaltkreises die zum fehlerfreien Betrieb erforderliche Mindesttemperatur Tₘᵢₙ aufweisen.

Vorzugsweise ist der Aufwärmmodus zweistufig ausgebildet. Bei einem zweistufigen Aufwärmmodus wird der Schaltkreis, wenn die festgestellte Temperaturcharakteristik eine zweite vorgegebene Bedingung erfüllt, beispielsweise wenn die Schaltkreistemperatur unter die Mindesttemperatur abzusinken droht, in einem nicht-exklusiven Aufwärmmodus betrieben, in dem es möglich ist, zusätzlich zu normalen energieverbrauchenden Operationen auch solche energieverbrauchende Operationen auf dem Schaltkreis durchzuführen, bei denen es unbedeutend ist, ob sie fehlerfrei durchgeführt werden. Dabei ist der nicht-exklusive Aufwärmmodus vorzugsweise eingerichtet, normale Operationen zum Erwärmen des Schaltkreises prioritär auszuführen. Das heißt, in dieser Stufe des Aufwärmmodus werden vorzugsweise nur "normale" Operationen ausgeführt, dies jedoch vermehrt oder zumindest zeitlich und/oder örtlich verteilt, um so z.B. das Absinken der Schaltkreistemperatur unter die Mindestbetriebstemperatur zu verhindern.

Derartige normale Operationen können insbesondere Speicherzugriffe sein, durch die es, würden sie fehlerhaft ausgeführt, zu Datenverlusten kommen könnte. Diese normalen Operationen sind mit einem über die Wärmegewinnung hinausgehenden Nutzen verbunden und werden daher in dem nicht-exklusiven Aufwärmmodus zum Erwärmen des Schaltkreises bevorzugt.

Dementsprechend wird die zweite vorgegebene Bedingung so gewählt, dass der Schaltkreis nur dann in dem nicht-exklusiven Aufwärmmodus betrieben wird, wenn auf Grund der festgestellten Temperaturcharakteristik davon auszugehen ist, dass der Schaltkreis oder zumindest wesentliche Teile davon zumindest die zum fehlerfreien Betrieb erforderliche Mindesttemperatur Tₘᵢₙ aufweist.

Durch den nicht-exklusiven Aufwärmmodus kann also die Temperatur des Schaltkreises oder wesentlicher Teile des Schaltkreises oberhalb der zum fehlerfreien Betrieb des Schaltkreises erforderlichen Temperatur Tₘᵢₙ gehalten werden, wohingegen durch den exklusiven Aufwärmmodus die Temperatur des Schaltkreises oder wesentlicher Teile des Schaltkreises erst auf oder über eine zum Betrieb des Schaltkreises erforderliche Temperatur Tₘᵢₙ angehoben werden kann.

Wenn die festgestellte Temperatur bei Initiierung des Schaltkreises unterhalb der unteren kritischen Temperatur liegt, wird der Schaltkreis vorzugsweise nach Verstreichen einer vorgegebenen Zeitspanne ab Initiierung in dem nicht-exklusiven Aufwärmmodus betrieben.

Diese Zeitspanne ist so zu bemessen, dass nach Verstreichen der Zeitspanne wesentliche oder vorzugsweise alle Bereiche des Schaltkreises durch den zuvor beschriebenen exklusiven Aufwärmmodus zumindest auf die für den fehlerfreien Betrieb erforderliche Temperatur Tₘᵢₙ erwärmt wurden. Dabei kann die Zeitspanne vorgegeben sein oder von dem System in Abhängigkeit von der festgestellten Temperatur oder einer Charakteristik der festgestellten Temperatur festgelegt werden.

Gemäß einer weiteren bevorzugten Ausführungsform wird der Schaltkreis in dem nicht-exklusiven Aufwärmmodus betrieben, wenn die festgestellte Temperatur oberhalb der vorgegebenen unteren kritischen Temperatur liegt und gleichzeitig unterhalb einer vorgegebenen oberen kritischen Temperatur liegt.

Bei dieser Ausführungsform wird dementsprechend davon ausgegangen, dass, wenn die festgestellte Temperatur oberhalb der vorgegebenen unteren kritischen Temperatur liegt, die wesentlichen oder alle Bereiche des Schaltkreises zumindest die für den fehlerfreien Betrieb erforderliche Temperatur Tₘᵢₙ aufweisen, was das Betreiben des Schaltkreises in dem nicht-exklusiven Aufwärmmodus erlaubt.

Die obere kritische Temperatur ist dabei ein Temperaturwert des Schaltkreises oder der Umgebung des Schaltkreises, oberhalb dessen ein Erwärmen des Schaltkreises nicht mehr erforderlich ist, um dessen zuverlässigen Betrieb zu gewährleisten, d.h. um die Temperatur des Schaltkreises oder wesentlicher Teile des Schaltkreises oberhalb der zum fehlerfreien Betrieb des Schaltkreises erforderlichen Temperatur Tₘᵢₙ zu halten.

Idealerweise wird nicht nur an Hand des Wertes der festgestellten Temperatur, sondern auch des Verlaufs der festgestellten Temperatur festgelegt, ob der Schaltkreis in dem exklusiven oder dem nicht-exklusiven Aufwärmmodus zu betreiben ist. Beispielsweise kann, wenn die festgestellte Temperatur sehr schnell abfällt, ein Wechsel von dem nicht exklusiven in den exklusiven Aufwärmmodus schon bei einer höheren festgestellten Temperatur erforderlich sein, als bei einem langsamen Absinken der festgestellten Temperatur.

Gemäß einem zweiten Aspekt der Erfindung wird der Schaltkreis des Systems ständig in einem Aufwärmmodus betrieben, in dem auf dem Schaltkreis ein vorgegebenes Minimum an energieverbrauchenden Operationen durchgeführt wird, um auf diese Weise zu jeder Betriebszeit eine Mindesterwärmung des Schaltkreises zu bewirken.

Bei dieser Ausführungsform umfasst das System vorzugsweise keinerlei Mittel zum Bestimmen einer Temperatur oder einer Temperaturcharakteristik des Schaltkreises oder einer Temperatur oder einer Temperaturcharakteristik der Umgebung, die geeignet ist, Rückschlüsse auf die Temperatur des Schaltkreises zu ziehen. Zumindest wird der Aufwärmmodus vorzugsweise nicht in Abhängigkeit von einer festgestellten Temperaturcharakteristik variiert.

Bei diesem zweiten Aspekt der Erfindung wird der Schaltkreis vorzugsweise in einem nicht-exklusiven Aufwärmmodus betrieben, in dem es möglich ist, zusätzlich zu normalen energieverbrauchenden Operationen auch solche energieverbrauchende Operationen auf dem Schaltkreis durchzuführen, bei denen es unbedeutend ist, ob sie fehlerfrei durchgeführt werden, wobei wiederum normale Operationen zum Erwärmen des Schaltkreises bevorzugt und daher prioritär ausgeführt werden.

Besonders bevorzugt wird der Schaltkreis jedoch bei diesem zweiten Aspekt der Erfindung direkt nach Initiierung des Schaltkreises zunächst in einem exklusiven Aufwärmmodus betrieben, in dem ausschließlich solche energieverbrauchenden Operationen durchgeführt werden, bei denen es unbedeutend ist, ob sie fehlerfrei durchgeführt werden. Erst nach Verstreichen einer vorgegebenen Zeitspanne ab Initiierung des Schaltkreises wird der Schaltkreis dann in dem nicht-exklusiven Aufwärmmodus betrieben.

Der im Zusammenhang mit dem zweiten Aspekt der Erfindung beschriebene nicht-exklusive / exklusive Aufwärmmodus entspricht dem im Zusammenhang mit dem ersten Aspekt der Erfindung beschriebenen nicht-exklusiven /exklusiven Aufwärmmodus in allen Eigenschaften, wobei jedoch gemäß dem zweiten Aspekt der Erfindung ständig ein vorgegebenes Minimum an energieverbrauchenden Operationen durchgeführt wird, weil der Aufwärmmodus ständig aktiv ist, wenn das System in Betrieb ist. Dementsprechend sind die zuvor im Zusammenhang mit dem nicht-exklusiven / exklusiven Aufwärmmodus des ersten Aspekts der Erfindung genannten Operationen auch mögliche Operationen des nicht-exklusiven / exklusiven Aufwärmmodus des zweiten Aspekts der Erfindung.

Falls keine Mittel zum Bestimmen der Temperatur des Schaltkreises vorgesehen sind, ist die Temperatur des Schaltkreises bei dessen Initiierung unbekannt. Es kann jedoch angenommen werden, dass die Schaltkreistemperatur niemals unter die niedrigste, normalerweise auftretende Umgebungstemperatur sinkt. Durch das Betreiben des Schaltkreises in dem exklusiven Aufwärmmodus nach seiner Initiierung kann der Schaltkreis oder können zumindest wesentliche Teile davon zunächst um eine Temperaturdifferenz ΔT auf eine Temperatur erwärmt werden, die selbst bei der niedrigsten normalerweise auftretenden Umgebungstemperatur zuverlässig über der zum fehlerfreien Betrieb des Schaltkreises erforderlichen Temperatur Tₘᵢₙ liegt.

Die Zeitspanne, nach deren Verstreichen der Schaltkreis in den nicht-exklusiven Aufwärmmodus wechselt, wird dabei so festgelegt, dass davon ausgegangen werden kann, dass in ihr eine Erwärmung um ΔT stattfindet. Das vorgegebene Minimum an energieverbrauchenden Operationen wird dementsprechend so gewählt, dass die Temperatur des Schaltkreises oder wesentlicher Teile davon nach Initiierung des Schaltkreises zuverlässig auf die vorgegebene Mindesttemperatur Tₘᵢₙ angehoben wird. Nach Verstreichen der Zeitspanne kann die Temperatur des Schaltkreises dann in dem nicht exklusiven Aufwärmmodus über der zum fehlerfreien Betrieb des Schaltkreises erforderlichen Temperatur Tₘᵢₙ gehalten werden.

Bei beiden Aspekten der Erfindung umfasst der elektronische Schaltkreis vorzugsweise zumindest einen Mikrochip oder der Schaltkreis ist Bestandteil eines Mikrochips. Im Zusammenhang mit einem Mikrochip ist die Erfindung besonders vorteilhaft einsetzbar, weil bei einem Mikrochip diverse wichtige Komponenten auf kleinster Fläche angeordnet sind und gleichzeitig der Siliziumträger des Chips eine Wärmeleitung und damit gleichzeitig ein räumlich gesehen gleichmäßiges Erwärmen der Komponenten des Chips ermöglicht.

Zudem werden bei beiden Aspekten der Erfindung die energieverbrauchenden Operationen des Aufwärmmodus bevorzugt derart ausgeführt, dass sie in voneinander entfernten Bereichen des Schaltkreises Wärmeerzeugung verursachen. Hierdurch kann eine räumlich gesehen gleichmäßige Erwärmung des Schaltkreises erzielt werden.

Weitere Merkmale und Vorteile der Erfindung ergeben sich aus der folgenden Beschreibung der erfindungsgemäßen Ausführungsbeispiele sowie weiterer Ausführungsalternativen im Zusammenhang mit den Zeichnungen, die schematisch zeigen:
- Figur 1:: ein System gemäß einem ersten Ausführungsbeispiel, das ein Kommunikationsmodul mit einem Schaltkreis, einer Temperaturmesseinrichtung und einer Steuereinrichtung umfasst,
- Figur 2:: ein System gemäß einem zweiten Ausführungsbeispiel, das ein Kommunikationsmodul mit einem Schaltkreis und einer Steuereinrichtung und davon getrennt eine Temperaturmesseinrichtung umfasst,
- Figur 3:: ein System gemäß einem dritten Ausführungsbeispiel, das im Wesentlichen dem von Figur 2 entspricht, wobei allerdings auch die Steuereinrichtung getrennt von dem Kommunikationsmodul vorgesehen ist, und
- Figur 4:: ein System gemäß einem vierten Ausführungsbeispiel, umfassend ein Kommunikationsmodul mit einem Schaltkreis und einer Steuereinrichtung, bei dem der Schaltkreis im Betrieb permanent durch energieverbrauchende Operationen erwärmt wird.

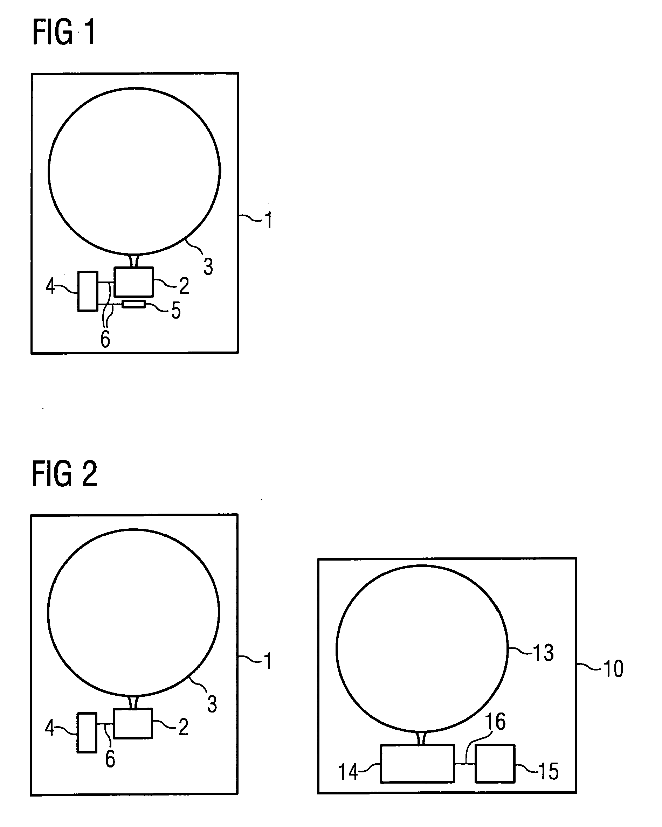

In Figur 1 ist schematisch ein Kommunkationsmodul 1 dargestellt. Dieses umfasst einen elektronischen Schaltkreis 2 zur Verarbeitung von Daten, der mit einer Antennenspule 3 zur Datenübertragung verbunden ist, eine Steuereinrichtung 4, eine Temperaturmesseinrichtung 5 sowie Datenleitungen 6, mit denen die zuvor genannten Komponenten des Schaltkreises 2 verbunden sind, um Daten auszutauschen. Der Schaltkreis 2 umfasst vorzugsweise zumindest einen Chip oder ist Bestandteil eines Chips (nicht dargestellt).

Die Steuereinrichtung 4 ist dabei eingerichtet, eine Temperaturcharakteristik der mit der Temperaturmesseinrichtung 5 gemessenen Temperatur oder des Verlaufs der gemessenen Temperatur festzustellen und, wenn die festgestellte Temperaturcharakteristik mindestens eine vorgegebene Bedingung erfüllt (beispielsweise eine niedrige Umgebungstemperatur anzeigt), den Schaltkreis 2 in einem Aufwärmmodus betrieben, in dem auf dem Schaltkreis 2 energieverbrauchende Operationen durchgeführt werden, die den Schaltkreis 2 über einer Mindesttemperatur halten. Dabei werden in dem Aufwärmmodus bedarfsweise auch energieverbrauchende Operationen auf dem Schaltkreis 2 durchgeführt, die keine über die Wärmegewinnung hinausgehende Funktion haben, um sicherzustellen, dass der Schaltkreis 2 ausreichend erwärmt wird. Zum Erwärmen des Schaltkreises 2 werden jedoch Operationen, die eine über die Wärmegewinnung hinausgehenden Funktion haben, bevorzugt.

Die Steuereinrichtung 4 steuert dieses Erwärmen des Schaltkreises 2 derart, dass die Temperatur des Schaltkreises 2 oder zumindest wesentlicher Bereiche des Schaltkreises 2 eine vorgegebene Mindesttemperatur Tₘᵢₙ nicht unterschreitet, unterhalb derer ein sicherer und zuverlässiger Betrieb des Schaltkreises 2 nicht mehr gewährleistet ist. Die vorgegebene Bedingung für die festzustellende Temperaturcharakteristik wird dementsprechend festgelegt.

Vor Initiierung des Schaltkreises 2 kann die Steuereinrichtung 4 den Schaltkreis 2 jedoch nicht mit den energieverbrauchenden Operationen erwärmen. Daher kann es vorkommen, dass die Temperatur des Schaltkreises 2 bei Initiierung des Schaltkreises 2 unterhalb der Mindesttemperatur Tₘᵢₙ liegt. Die Steuereinrichtung 4 führt dann bei und/oder nach Initiierung des Schaltkreises 2 nur solche energieverbrauchenden Operationen auf dem Schaltkreis 2 durch, die für die Funktion des Systems unkritisch sind, um die Temperatur des Schaltkreises 2 über die Mindesttemperatur Tₘᵢₙ anzuheben, bevor funktionsrelevante Operationen durchgeführt werden.

Die Temperaturmesseinrichtung 5 ist vorzugsweise in direkter Nähe des Schaltkreises 2 angeordnet und misst dementsprechend eine Temperatur des Schaltkreises 2, d.h. die Temperaturmesseinrichtung stellt die entsprechende Temperatur und deren Verlauf fest. Dabei kann die Temperaturmesseinrichtung 5 auch Bestandteil des Schaltkreises 2 sein (nicht dargestellt), insbesondere auch eines Chips, der Bestandteil des Schaltkreises 2 ist, oder eines Chips, der den Schaltkreis 2 umfasst. Anstatt die Schaltkreistemperatur zu messen, kann die Temperaturmesseinrichtung 5 auch derart angeordnet sein, dass sie eine Temperatur in der Umgebung des Schaltkreises 2 erfasst. Die Temperaturmesseinrichtung 5 übermittelt die erfasste Temperatur mittels der Datenleitung 6 an die Steuereinrichtung 4, die das Erwärmen des Schaltkreises 2 steuert. Die Steuereinrichtung kann wiederum auch Bestandteil des Schaltkreises 2 sein (nicht dargestellt). Die Steuereinrichtung 4 steuert das Erwärmen an Hand einer Charakteristik der gemessenen Temperatur oder des Verlaufs derselben.

Gemäß einer alternativen Ausführungsform, wird sowohl eine Temperatur des Schaltkreises 2 als auch eine Temperatur in der Umgebung des Schaltkreises 2 bestimmt, um das Erwärmen des Schaltkreises 2 möglichst genau zu steuern.

An Hand der festgestellten Temperaturcharakteristik legt die Steuereinrichtung 4 fest, ob der Schaltkreis 2 entweder:
a.) in einem exklusiven Aufwärmmodus betrieben wird, in dem ausschließlich solche energieverbrauchenden Operationen durchgeführt werden, bei denen es unbedeutend ist, ob sie fehlerfrei durchgeführt werden, oder
b.) in einem nicht-exklusiven Aufwärmmodus betrieben wird, in dem es möglich ist, zusätzlich zu normalen energieverbrauchenden Operationen auch solche energieverbrauchende Operationen auf dem Schaltkreis 2 durchzuführen, bei denen es unbedeutend ist, ob sie fehlerfrei durchgeführt werden, wobei der nicht-exklusive Aufwärmmodus vorzugsweise so eingerichtet ist, normale Operationen zum Erwärmen des Schaltkreises 2 zu bevorzugen, oder
c.) nicht in einem Aufwärmmodus betrieben wird.

Wenn die festgestellte Temperaturcharakteristik eine erste vorgegebene Bedingung erfüllt, wird der Schaltkreis 2 in dem exklusiven Aufwärmmodus betrieben. Die erste vorgegebene Bedingung wird dabei im einfachsten Fall so gewählt, dass der Schaltkreis 2 zumindest dann in dem exklusiven Aufwärmmodus betrieben wird, wenn die Schaltkreistemperatur und/oder die Umgebungstemperatur eine vorgegebene untere kritische Temperatur unterschreiten, unterhalb derer ein fehlerfreier Betrieb nicht mehr gewährleistet ist. Diese untere kritische Temperatur kann gleich der Mindesttemperatur Tₘᵢₙ gesetzt werden, wird vorzugsweise aber auf eine Temperatur geringfügig über dieser Mindesttemperatur festgelegt.

Wenn die festgestellte Temperaturcharakteristik eine zweite vorgegebene Bedingung erfüllt, wird der Schaltkreis 2 in dem nicht-exklusiven Aufwärmmodus betrieben. Diese zweite vorgegebene Bedingung wird im einfachsten Fall so gewählt, dass der Schaltkreis 2 nur dann in dem nicht-exklusiven Aufwärmmodus betrieben wird, wenn die Schaltkreistemperatur und/oder die Umgebungstemperatur über der unteren kritischen Temperatur liegt, oberhalb derer sicher angenommen werden kann, dass der Schaltkreis oder zumindest wesentliche Teile davon zumindest die zum fehlerfreien Betrieb erforderliche Mindesttemperatur Tₘᵢₙ aufweist, und gleichzeitig unter einer vorgegebenen oberen kritischen Temperatur.

Durch den nicht-exklusiven Aufwärmmodus wird dabei die Temperatur des Schaltkreises 2 oder wesentlicher Teile davon oberhalb der zum fehlerfreien Betrieb des Schaltkreises 2 erforderlichen Temperatur Tₘᵢₙ gehalten, wohingegen durch den exklusiven Aufwärmmodus die Temperatur des Schaltkreises 2 oder wesentlicher Teile davon erst auf oder über eine zum Betrieb des Schaltkreises 2 erforderliche Temperatur Tₘᵢₙ angehoben wird.

Wenn die gemessene Temperatur bei Initiierung des Schaltkreises 2 unterhalb der unteren kritischen Temperatur liegt, kann der Schaltkreis 2 dann nach Verstreichen einer vorgegebenen Zeitspanne ab Initiierung in dem nicht-exklusiven Aufwärmmodus betrieben werden, wenn diese Zeitspanne so bemessen ist, dass nach Verstreichen der Zeitspanne wesentliche oder vorzugsweise alle Bereiche des Schaltkreises 2 durch den exklusiven Aufwärmmodus zuverlässig über die für den fehlerfreien Betrieb erforderliche Temperatur Tₘᵢₙ erwärmt wurden. Dabei kann die Zeitspanne vorgegeben sein oder von dem System in Abhängigkeit von der gemessenen Temperatur oder einer Charakteristik der gemessenen Temperatur festgelegt werden.

Falls die Steuereinrichtung 4 an Hand der Temperaturcharakteristik feststellt, dass kein Abfall der Temperatur des Schaltkreises 2 unter die zum fehlerfreien Betrieb erforderliche Mindesttemperatur Tₘᵢₙ zu erwarten ist, wird der Schaltkreis 2 nicht in dem Aufwärmmodus betrieben.

Dementsprechend wird der Schaltkreis 2 nicht in einem Aufwärmmodus betrieben, wenn die gemessene Temperatur oberhalb der oberen kritischen Temperatur liegt, d.h. einer Temperatur, oberhalb derer ein Betrieb des Schaltkreises 2 in einem Aufwärmmodus nicht mehr erforderlich ist.

Ergänzend wird auch der komplexe zeitliche Verlauf der gemessenen Temperatur ausgewertet und herangezogen, um zu entscheiden, wann der Schaltkreis 2 in dem exklusiven oder dem nicht-exklusiven Aufwärmmodus oder im normalen Betriebsmodus zu betreiben ist. Beispielsweise wird, wenn die festgestellte Temperatur sehr schnell abfällt, ein Wechsel von dem nicht exklusiven in den exklusiven Aufwärmmodus (oder vom normalen Betriebsmodus in den nicht-exklusiven Aufwärmmodus) schon bei einer höheren festgestellten Temperatur ausgeführt, als bei einem langsamen Absinken der festgestellten Temperatur.

Die energieverbrauchenden Operationen des Aufwärmmodus werden derart ausgeführt oder ausgewählt, dass sie in voneinander entfernten Bereichen des Schaltkreises Wärmeerzeugung verursachen, um dadurch eine räumlich gesehen gleichmäßigere Erwärmung des Schaltkreises zu ermöglichen. Beispielsweise können hierzu Operationen auf einem Prozessor des Schaltkreises und einem EEPROM-Speicher des Schaltkreises durchgeführt werden.

Dabei wird das Layout des Schaltkreises berücksichtigt. Insbesondere bei einem Chip kann auch dessen Wärmeleitfähigkeit berücksichtigt werden. Durch das räumlich gesehen gleichmäßigere Erwärmen des Schaltkreises wird eine geringere Energiemenge benötigt, um den Schaltkreis oder zumindest wesentliche Teile davon über die zum Betrieb des Schaltkreises erforderliche Mindesttemperatur Tₘᵢₙ anzuheben und über dieser Temperatur zu halten.

In Fig. 2 ist schematisch ein System gemäß einem zweiten Ausführungsbeispiel dargestellt, das ein dem Kommunikationsmodul 1 von Figur 1 im Wesentlichen entsprechendes erstes Kommunikationsmodul 1 umfasst, das jedoch keine Temperaturmesseinrichtung besitzt. Vielmehr ist ein zweites Kommunikationsmodul 10 mit einer Antennenspule 13, einer Steuereinrichtung 14, einer Temperaturmesseinrichtung 15 und Datenleitungen 16 zum Verbinden der zuvor genannten Komponenten vorgesehen. Dabei misst die Temperaturmesseinrichtung 15 eine Temperatur der Umgebung des Schaltkreises 2. Diese Temperatur wird mittels der Datenleitung 16 an die Steuereinrichtung 14 übermittelt, die diese mittels der Antennenspule 13 an das erste Kommunikationsmodul 1 überträgt. Die Steuereinrichtung 4 des ersten Kommunikationsmoduls 1 steuert dementsprechend basierend auf einer Charakteristik der mittels der Temperaturmesseinrichtung 15 des zweiten Kommunikationsmoduls 10 erfassten Temperatur oder deren Verlaufs das gezielte Erwärmen des Schaltkreises 2, wie bereits zuvor im Zusammenhang mit Fig. 1 erläutert.

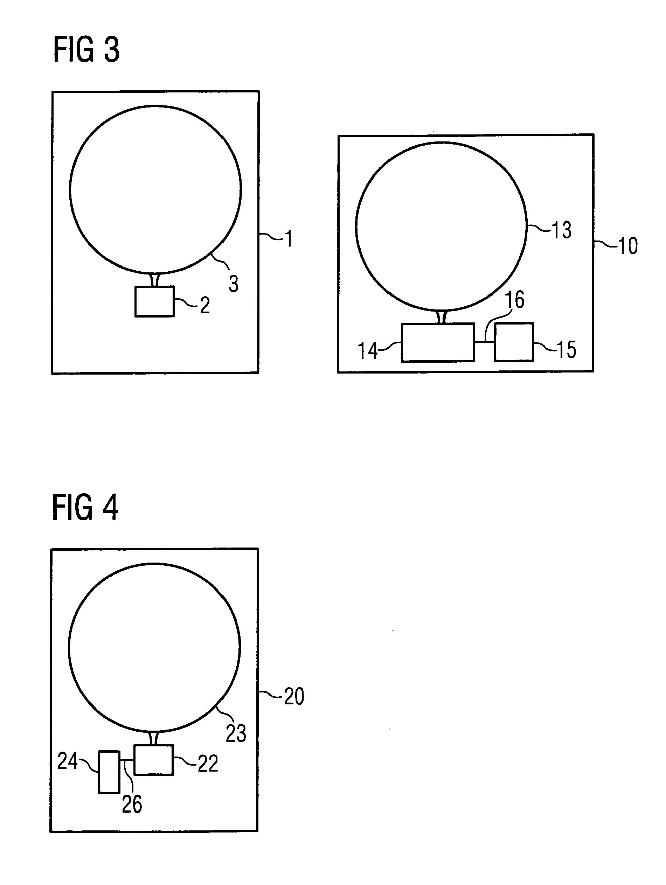

Eine Abwandlung der zuvor im Zusammenhang mit Figur 2 dargestellten Ausführungsform ist als drittes Ausführungsbeispiel in Figur 3 dargestellt. Hier umfasst das erste Kommunikationsmodul 1 auch keine Steuereinrichtung. Die zuvor beschriebenen Aufgaben der Steuereinrichtung 4 des ersten Kommunikationsmoduls 1 werden von der Steuereinrichtung 14 des zweiten Kommunikationsmoduls 10 übernommen.

Weiterhin ist in Analogie zu den in den Figuren 2 und 3 dargestellten Ausführungsformen auch eine (nicht dargestellte) Ausführungsform möglich, bei der die Temperaturmesseinrichtung 5 Bestandteil des ersten Kommunikationsmoduls 1 ist, wobei das erste Kommunikationsmodul 1 jedoch keine Steuereinrichtung umfasst, sondern deren Aufgaben von der Steuereinrichtung 14 des zweiten Kommunikationsmoduls 10 übernommen werden.

In Figur 4 ist schematisch ein viertes Ausführungsbeispiel dargestellt, das ein Kommunikationsmodul 20 mit einer Sendespule 23, einem Schaltkreis 22, einer Steuereinrichtung 24 und Datenleitungen 26 zum Verbinden der zuvor genannten Komponenten umfasst.

Dabei ist die Steuereinrichtung 24 eingerichtet, den Schaltkreis 22 ständig in einem Aufwärmmodus zu betreiben, indem auf dem Schaltkreis 22 immer ein vorgegebenes Minimum an energieverbrauchenden Operationen durchgeführt wird, um auf diese Weise eine Mindesterwärmung des Schaltkreises 22 zu bewirken. Im Gegensatz zu den zuvor beschriebenen Ausführungsbeispielen ist hier keine Temperaturmessung erforderlich und dementsprechend keine Temperaturmesseinrichtung vorgesehen.

Direkt nach Initiierung des Schaltkreises 22 wird dieser in dem zuvor beschriebenen nicht-exklusiven Aufwärmmodus betrieben und nach Verstreichen einer vorgegebenen Zeitspanne ab Initiierung des Schaltkreises 22 wird in den zuvor beschriebenen nicht-exklusiven Aufwärmmodus gewechselt, wobei anders als bei den vorherigen Ausführungsbeispielen ständig ein vorgegebenes Minimum an energieverbrauchenden Operationen durchgeführt wird.

Die Zeitspanne, nach deren Verstreichen der Schaltkreis 22 in den nicht-exklusiven Aufwärmmodus wechselt, wird vorab unter Heranziehung einer zu erwartenden niedrigsten Umgebungstemperatur so festgelegt, dass nach Verstreichen der Zeitspanne die Temperatur wesentlicher oder vorzugsweise aller Bereiche des Schaltkreises 22 mit Sicherheit oberhalb einer zum fehlerfreien Betrieb des Schaltkreises erforderlichen Temperatur Tₘᵢₙ liegt. Durch die in dem nicht-exklusiven Aufwärmmodus durchgeführten energieverbrauchenden Operationen wird dann die Temperatur des Schaltkreises 22 oder zumindest wesentlicher Teile davon über der zum fehlerfreien Betrieb des Schalkreises 22 erforderlichen Temperatur Tₘᵢₙ gehalten. Das vorgegebene Minimum an energieverbrauchenden Operationen wird dementsprechend so gewählt, dass die Temperatur des Schaltkreises 22 oder wesentlicher Teile davon, nach einer möglichst kurzen Zeitspanne nach Initiierung des Schaltkreises 22 stets über der zum fehlerfreien Betrieb des Schaltkreises 22 erforderlichen Temperatur Tₘᵢₙ liegt.

Wie zuvor im Zusammenhang mit Figur 1 dargestellt, werden auch bei dem Ausführungsbeispiel von Figur 4 die energieverbrauchenden Operationen des Aufwärmmodus derart ausgeführt oder ausgewählt, dass sie in voneinander entfernten Bereichen des Schaltkreises 22 Wärmeerzeugung verursachen, um dadurch eine räumlich gesehen gleichmäßige Erwärmung des Schaltkreises 22 zu ermöglichen.

Auch bei dem Ausführungsbeispiel von Fig. 4 kann die Steuereinrichtung 24 Bestandteil des Schaltkreises 22 sein (nicht dargestellt). Zudem ist es auch denkbar, dass bei dem in Fig. 4 dargestellten Ausführungsbeispiel die Steuereinrichtung 24, in Analogie zu dem in Fig. 3 dargestellten Ausführungsbeispiel, auf einem zweiten Kommunikationsmodul vorgesehen ist (nicht dargestellt).

Bei allen zuvor erläuterten Ausführungsbeispielen kann es sich bei dem Kommunikationsmodul 1 um ein M2M-Kommunikationsmodul handeln. Derartige M2M-Kommunikationsmodule besitzen meist einen Schaltkreis 2 bzw. 22, der die wesentlichen Bestandteile des M2M-Moduls, d.h. einen Prozessor, einen RAM-Speicher, einen nicht-flüchtigen Speicher sowie eine Ein-und Ausgabeeinheit umfasst. Dabei weist der Schaltkreis nur eine Größe von z.B. ca. 9 mm² auf. Dies ermöglicht es, alle zuvor genannten Komponenten des Schaltkreises durch die energieverbrauchenden Operationen des Aufwärmmodus räumlich gesehen besonders gleichmäßig zu erwärmen.

Alle zuvor dargestellten Ausführungsformen können besonders vorteilhaft auch im Zusammenhang mit RFID (Radio Frequency Identification)-Tags oder NFC (Near Field Communication)-Tags angewendet werden. Dabei kann insbesondere eine Temperaturmesseinrichtung 15 und/oder die Steuereinrichtung 14 als Bestandteil einer Zentraleinheit 10 (entsprechend dem zweiten Kommunikationsmodul 10 der Figuren 2 und 3) vorgesehen sein, um nicht alle RFID-Tags mit einer Temperaturmesseinrichtung 5 und/oder einer entsprechenden Steuereinrichtung 4 ausstatten zu müssen.

Die an Hand der Figuren dargestellten Merkmale und Vorteile der Erfindung sind nicht auf Kommunikationsmodule beschränkt, sondern ergeben sich genauso im Zusammenhang mit beliebigen elektronischen Schaltkreisen zur Verarbeitung von Daten. Zur Veranschaulichung wurde eine Kommunikationsmodul gewählt, da insbesondere M2M-Systeme, die derartige Kommunikationsmodule umfassen, häufig in extremen Umgebungen eingesetzt werden, gerade um die Anwesenheit von Betriebspersonal auf Grund extremer Umgebungsbedingungen überflüssig zu machen.

## Patentansprüche

1. System (1,10), umfassend einen elektronischen Schaltkreis (2) zur Verarbeitung von Daten, der vorzugsweise Bestandteil eines machine-to-machine (M2M) - Kommunikationsmoduls (1) ist, wobei das System (1,10) eingerichtet ist, eine Temperaturcharakteristik festzustellen und, wenn die festgestellte Temperaturcharakteristik mindestens eine vorgegebene Bedingung erfüllt, den Schaltkreis (2) in einem Aufwärmmodus zu betreiben, in dem auf dem Schaltkreis (2) energieverbrauchende Operationen durchgeführt werden, die den Schaltkreis (2) über einer Mindesttemperatur halten, **dadurch gekennzeichnet, dass** der Aufwärmmodus so angelegt ist, dass bedarfsweise auch solche energieverbrauchenden Operationen auf dem Schaltkreis (2) durchgeführt werden, die keine über die Wärmegewinnung hinausgehende Funktion haben.

2. System nach Anspruch 1, **gekennzeichnet durch** eine Einrichtung (5; 15) zum Feststellen einer Temperatur des Schaltkreises (2) oder einer Temperatur in der Umgebung des Schaltkreises (2) oder eines Verlaufs einer Temperatur des Schaltkreises (2) oder einer Temperatur in der Umgebung des Schaltkreises (2).

3. System (1,10) nach Anspruch 1 oder 2, **dadurch gekennzeichnet, dass** das System (1,10) eingerichtet ist, den Schaltkreis (2), wenn die festgestellte Temperaturcharakteristik eine erste vorgegebene Bedingung erfüllt, in einem exklusiven Aufwärmmodus zu betreiben, in dem ausschließlich solche energieverbrauchenden Operationen durchgeführt werden, bei denen es unbedeutend ist, ob sie fehlerfrei durchgeführt werden.

4. System nach Anspruch 3, **dadurch gekennzeichnet, dass** das System (1,10) eingerichtet ist, wenn die festgestellte Temperatur unterhalb einer vorgegebenen unteren kritischen Temperatur liegt, den Schaltkreis (2) in dem exklusiven Aufwärmmodus zu betreiben.

5. System (1,10) nach Anspruch 3 oder 4, **dadurch gekennzeichnet, dass** das System (1,10) eingerichtet ist, den Schaltkreis (2), wenn die festgestellte Temperaturcharakteristik eine zweite vorgegebene Bedingung erfüllt, in einem nicht-exklusiven Aufwärmmodus zu betreiben, in dem es möglich ist, zusätzlich zu normalen energieverbrauchenden Operationen auch solche energieverbrauchende Operationen auf dem Schaltkreis (2) durchzuführen, bei denen es unbedeutend ist, ob sie fehlerfrei durchgeführt werden, wobei der nicht-exklusive Aufwärmmodus vorzugsweise eingerichtet ist, normale Operationen zum Erwärmen des Schaltkreises (2) prioritär auszuführen.

6. System (1,10) nach Anspruch 5, **dadurch gekennzeichnet, dass** das System (1,10) eingerichtet ist, wenn die festgestellte Temperatur bei Initiierung des Schaltkreises (2) unterhalb einer vorgegebenen unteren kritischen Temperatur liegt, den Schaltkreis (2) nach Verstreichen einer vorgegebenen Zeitspanne ab Initiierung in dem nicht-exklusiven Aufwärmmodus zu betreiben.

7. System (1,10) nach Anspruch 5, **dadurch gekennzeichnet, dass** das System (1,10) eingerichtet ist, wenn die festgestellte Temperatur oberhalb einer vorgegebenen unteren kritischen Temperatur liegt und gleichzeitig unterhalb einer vorgegebenen oberen kritischen Temperatur liegt, den Schaltkreis (2) in dem nicht-exklusiven Aufwärmmodus zu betreiben.

8. System (20), umfassend einen elektronischen Schaltkreis (22) zur Verarbeitung von Daten, der vorzugsweise Bestandteil eines machine-to-machine (M2M) - Kommunikationsmoduls ist, **dadurch gekennzeichnet, dass** das System (20) eingerichtet ist, den Schaltkreis (22) ständig in einem Aufwärmmodus zu betreiben, in dem auf dem Schaltkreis ein vorgegebenes Minimum an energieverbrauchenden Operationen durchgeführt wird, um auf diese Weise eine Mindesterwärmung des Schaltkreises (22) zu bewirken.

9. System (20) nach Anspruch 8, **dadurch gekennzeichnet, dass** das System (20) eingerichtet ist, den Schaltkreis (22) in einem nicht-exklusiven Aufwärmmodus zu betreiben, in dem es möglich ist, zusätzlich zu normalen energieverbrauchenden Operationen auch solche energieverbrauchende Operationen auf dem Schaltkreis (22) durchzuführen, bei denen es unbedeutend ist, ob sie fehlerfrei durchgeführt werden, wobei der nicht-exklusive Aufwärmmodus vorzugsweise so eingerichtet ist, dass normale Operationen zum Erwärmen des Schaltkreises prioritär ausgeführt werden und wobei das System (20) des Weiteren vorzugsweise so eingerichtet ist, dass der Schaltkreis (22) erst nach Verstreichen einer vorgegebenen Zeitspanne ab Initiierung des Schaltkreises (22) in dem nicht-exklusiven Aufwärmmodus betrieben wird.

10. System (20) nach Anspruch 8 oder 9, **dadurch gekennzeichnet, dass** das System (20) eingerichtet ist, den Schaltkreis (22) direkt nach Initiierung des Schaltkreises (22) in einem exklusiven Aufwärmmodus zu betreiben, in dem ausschließlich solche energieverbrauchenden Operationen durchgeführt werden, bei denen es unbedeutend ist, ob sie fehlerfrei durchgeführt werden.

11. System (1,10; 20) nach einem der vorhergehenden Ansprüche, **dadurch gekennzeichnet, dass** der elektronische Schaltkreis (2; 22) zumindest einen Mikrochip umfasst oder Bestandteil eines Mikrochips ist.

12. System (1,10; 20) nach einem der vorhergehenden Ansprüche, **dadurch gekennzeichnet, dass** das System (1,10; 20) eingerichtet ist, in dem Aufwärmmodus energieverbrauchende Operationen derart auszuführen, dass sie in voneinander entfernten Bereichen des Schaltkreises Wärmeerzeugung verursachen.

13. Verfahren zum Erwärmen eines elektronischen Schaltkreises (2) zur Verarbeitung von Daten, der vorzugsweise Bestandteil eines machine-to-machine (M2M) - Kommunikationsmoduls ist, umfassend die folgenden Schritte:
Feststellen einer Temperaturcharakteristik, wie z.B. einer Temperatur des Schaltkreises oder einer Temperatur in der Umgebung des Schaltkreises (2) oder eines Verlaufs einer Temperatur des Schaltkreises (2) oder einer Temperatur in der Umgebung des Schaltkreises (2), und
Betreiben des Schaltkreises (2) in einem Aufwärmmodus, wenn die festgestellte Temperaturcharakteristik mindestens eine vorgegebene Bedingung erfüllt, wobei in dem Aufwärmmodus auf dem Schaltkreis (2) energieverbrauchende Operationen durchgeführt werden, die den Schaltkreis (2) über einer Mindesttemperatur halten, **dadurch gekennzeichnet, dass**
der Aufwärmmodus so angelegt ist, dass bedarfsweise auch solche energieverbrauchenden Operationen auf dem Schaltkreis (2) durchgeführt werden, die keine über die Wärmegewinnung hinausgehende Funktion haben.

14. Verfahren nach Anspruch 13, **gekennzeichnet durch** das Betreiben des Schaltkreises (2) in einem exklusiven Aufwärmmodus, wenn die festgestellte Temperatur unterhalb einer vorgegebenen unteren kritischen Temperatur liegt, wobei in dem exklusiven Aufwärmmodus ausschließlich solche energieverbrauchende Operationen durchgeführt werden, bei denen es unbedeutend ist, ob sie fehlerfrei durchgeführt werden.

15. Verfahren nach Anspruch 13 oder 14, **gekennzeichnet durch** das Betreiben des Schaltkreises (2) in einem nicht-exklusiven Aufwärmmodus, wenn die festgestellte Temperatur oberhalb einer vorgegebenen unteren kritischen Temperatur liegt und gleichzeitig unterhalb einer vorgegebenen oberen kritischen Temperatur liegt, wobei in dem nicht-exklusiven Aufwärmmodus zusätzlich zu normalen energieverbrauchenden Operationen auch solche energieverbrauchende Operationen auf dem Schaltkreis (2) durchgeführt werden können, bei denen es unbedeutend ist, ob sie fehlerfrei durchgeführt werden, und wobei im nicht-exklusiven Aufwärmmodus vorzugsweise normale Operationen zum Erwärmen des Schaltkreises (2) prioritär ausgeführt werden.

16. Verfahren zum Erwärmen eines elektronischen Schaltkreises (22) zur Verarbeitung von Daten, der vorzugsweise Bestandteil eines machine-to-machine (M2M) - Kommunikationsmoduls ist, **dadurch gekennzeichnet, dass** der Schaltkreis (22) ständig in einem Aufwärmmodus betrieben wird, in dem auf dem Schaltkreis (22) ein vorgegebenes Minimum an energieverbrauchenden Operationen durchgeführt wird, um auf diese Weise eine Mindesterwärmung des Schaltkreises (22) zu bewirken.
